# EUROPEAN PATENT SPECIFICATION

(11) **EP 2 725 634 B1**
(45) Date of publication and mention of the grant of the patent: **03.04.2019**
(21) Application number: 13189202.8
(22) Date of filing: 18.10.2013
(51) Int. Cl.: H01L 51/52, C03C 17/245, C03C 17/34

(54) **Method of fabricating light extraction substrate for organic light-emitting diode**
Verfahren zur Herstellung eines Lichtextraktionssubstrats für eine organische lichtemittierende Diode
Procédé de fabrication de substrat d'extraction de lumière à diode électroluminescente organique

(30) Priority: 23.10.2012 KR 20120117834
(43) Date of publication of application: 30.04.2014
(73) Proprietor: Corning Precision Materials Co., Ltd., Asan-si, Chungcheongnam-do 336-841 (KR)
(72) Inventor: Choi, Eun Ho, 336-841 Asan-si ChungCheongNam-Do (KR); Park, June Hyoung, 336-841 Asan-si ChungCheongNam-Do (KR); Baek, Il Hee, 336-841 Asan-si ChungCheongNam-Do (KR); Yoo, Young Zo, 336-841 Asan-si ChungCheongNam-Do (KR)
(74) Representative: Gulde & Partner

(56) References cited:
- EP-A1- 2 698 837
- WO-A1-2012/141875
- US-A1- 2012 240 634
- US-A1- 2012 261 701
- ILLIBERI A ET AL: "Growth of ZnO:Al by high-throughput CVD at atmospheric pressure", JOURNAL OF CRYSTAL GROWTH, ELSEVIER, AMSTERDAM, NL, vol. 347, no. 1, 3 March 2012 (2012-03-03) , pages 56-61, XP028413610, ISSN: 0022-0248, DOI: 10.1016/J.JCRYSGRO.2012.03.007 [retrieved on 2012-03-13]
- B. S. RICHARDS ET AL: "Highly Porous Nanocluster TiO[sub 2] Films Deposited Using APCVD in an Excess of Water Vapor", JOURNAL OF THE ELECTROCHEMICAL SOCIETY, vol. 152, no. 7, 24 May 2005 (2005-05-24), page F71, XP055086906, ISSN: 0013-4651, DOI: 10.1149/1.1921687
- WEI ZHANG ET AL: "Comparison of APCVD to LPCVD Processes in the Manufacturing of ZnO TCO for Solar Applications", MRS PROCEEDINGS, vol. 1201, 1 January 2009 (2009-01-01), XP055086893, DOI: 10.1557/PROC-1201-H05-46

## Description

### CROSS REFERENCE TO RELATED APPLICATION

The present application claims priority from Korean Patent Application Number 10-2012-0117834 filed on October 23, 2012.

### BACKGROUND OF THE INVENTION

### Field of the Invention

The present invention relates to a method of fabricating a light extraction substrate for an organic light-emitting diode (OLED), and more particularly, to a method of fabricating a light extraction substrate for an OLED with which the scattering distribution of light that is emitted from the OLED can be artificially controlled.

### Description of Related Art

In general, an organic light-emitting diode (OLED) includes an anode, a light-emitting layer and a cathode. When a voltage is applied between the anode and the cathode, holes are injected from the anode into a hole injection layer and then migrate from the hole injection layer through a hole transport layer to the organic light-emitting layer, and electrons are injected from the cathode into an electron injection layer and then migrate from the electron injection layer through an electron transport layer to the light-emitting layer. Holes and electrons that are injected into the light-emitting layer recombine with each other in the light-emitting layer, thereby generating excitons. When such excitons transit from the excited state to the ground state, light is emitted.

Organic light-emitting displays including an OLED are divided into a passive matrix type and an active matrix type depending on a mechanism that drives an N*M number of pixels which are arranged in the shape of a matrix.

In an active matrix type, a pixel electrode which defines a light-emitting area and a unit pixel driving circuit which applies a current or voltage to the pixel electrode are positioned in a unit pixel area. The unit pixel driving circuit has at least two thin-film transistors (TFTs) and one capacitor. Due to this configuration, the unit pixel driving circuit can supply a constant current irrespective of the number of pixels, thereby realizing uniform luminance. The active matrix type organic light-emitting display consumes little power, and thus can be advantageously applied to high definition displays and large displays.

However, in the case of a planar light source device using OLEDs, a thin-film laminated structure causes at least half of light that is generated by the light-emitting layer to be lost by being reflected or absorbed by the interior or interface of an OLED instead of exiting forward. Therefore, additional current must be applied in order to produce a desired level of luminance. In this case, power consumption increases, thereby reducing the longevity of the device.

In order to overcome this problem, a technique for extracting light that would otherwise be lost inside the OLED or at the interface of the OLED to exit forward is required. This technique is referred to as light extraction technique. The scheme to overcome the problem using the light extraction technique is to remove any factor that prevents light that is lost inside the OLED or at the interface of the OLED from traveling forward or obstruct traveling of light. Methods that are generally used for this purpose include an external light extraction technique and an internal light extraction technique. The external light extraction technique reduces total internal reflection at the interface between the substrate and the air by forming concaves and convexes on the outermost surface of the substrate or coating the substrate with a layer having a different refractive index from the substrate. The internal light extraction technique reduces the waveguiding effect in which light travels along the interface between layers having different thicknesses and refractive indices without traveling forward by forming concaves and convexes on the surface between the substrate and a transparent electrode or coating the substrate with a layer having a different refractive index from the substrate.

Among them, the external light extraction technique using the concave-convex structure is required to control the shape and size of concaves and convexes depending on the use of an OLED since the scattering distribution and color coordinates of light may vary depending on the shape and size of the concaves and convexes. However, in the case of a polymer sheet type such as a micro lens array using the external light extraction technique, it is difficult to integrate the polymer sheet with the glass substrate since the polymer sheet is bonded to the glass substrate after fabrication of the OLED due to the thermal resistance problem and the polymer sheet is expensive. In contrast, in the case of coating the substrate with an inorganic material, it is difficult to control the shape of concaves and convexes. In particular, the light extraction layer is formed by photolithography in the related art, which causes complex problems, such as the increased cost due to the use of expensive equipment, the complicated process and hazardous substances produced by the process. US 2012/0261701 A1 addresses a light extraction substrate and WO 2012/141875 A1 concerns about an internal optical extraction layer for OLED devices.

EP2698837, having a priority date prior to the present invention but published after the priority date of the present invention, discloses a light extraction film for an OLED device comprising a first metal oxide layer with a texture surface and a second metal oxide layer on top of the first metal oxide layer having a different texture surface.

The information disclosed in the Background of the Invention section is provided only for better understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a method of fabricating a light extraction substrate for an organic light-emitting diode (OLED) with which the scattering distribution of light that is emitted from the OLED can be artificially controlled.

In an aspect of the present invention, provided is a method of fabricating a light extraction substrate for an OLED by APCVD. The method includes the step of forming a light extraction layer by depositing an inorganic oxide at least twice on a base substrate, thereby controlling a structure of a texture formed on a surface of the light extraction layer.

According to the present invention, depositing the inorganic oxide at least twice includes depositing the inorganic oxide on the base substrate at a first deposition temperature to form a first thin-film layer; and depositing the inorganic oxide at a second deposition temperature on the first thin-film layer to form a second thin-film layer, thereby forming the light extraction layer having a bilayer structure.

The thickness of the first thin-film layer ranges from 0.4 to 1.7µm, and the thickness of the second thin-film layer ranges from 2.1 to 2.9pm.

The first deposition temperature is different from the second deposition temperature.

In an embodiment of the invention, the first deposition temperature and the second deposition temperature may be different from each other and range from 350 to 640°C.

Depositing the inorganic oxide at least twice may be performed by an in-line process.

The inorganic oxide may be composed of a substance having a greater refractive index than the base substrate.

The inorganic oxide may be composed of one selected from a group of inorganic substances consisting of ZnO, SnO₂, SiO₂, Al₂O₃ and TiO₂.

The method may further include the step of injecting a dopant during or after depositing the inorganic oxide at least twice.

According to embodiments of the present invention, it is possible to artificially change the size, shape and distribution of concaves and convexes of the light extraction layer by forming the light extraction layer by APCVD that can cause a texture having a concave-convex shape to be naturally formed on the surface and performing deposition at least twice. This consequently makes it possible to control the scattering distribution of light emitted from an OLED applied for illumination depending on the use.

In addition, since the texture is naturally formed on the surface of the light extraction layer by APCVD, related-art photolithography for forming a light extraction layer becomes unnecessary. It is therefore possible to reduce fabrication time by reducing the number of process steps. Treatment cost is also reduced since hazardous substances produced by the process are decreased.

Furthermore, since the light extraction layer is formed by APCVD, it is possible to set the fabrication of the glass of the substrate and the formation of the light extraction layer in-line or on-line and the substrate and the light extraction layer are integrated with each other, whereby the resultant light extraction substrate can be made by mass-production.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 and FIG. 2 are schematic process views showing a method of fabricating a light extraction substrate for an organic light-emitting diode (OLED) according to an embodiment of the present invention;
FIG. 3 is a scanning electron microscopy (SEM) pictures showing the cross-section of a light extraction substrate for an OLED that is fabricated according to Example 1 of the present invention;
FIG. 4 is a graph showing a light scattering distribution measured from the light extraction substrate for an OLED that is fabricated according to Example 1 of the present invention;
FIG. 5 is a SEM pictures showing the cross-section of a light extraction substrate for an OLED that is fabricated according to Example 2 of the present invention;
FIG. 6 is a graph showing a light scattering distribution measured from the light extraction substrate for an OLED that is fabricated according to Example 2 of the present invention;
FIG. 7 is a SEM pictures showing the cross-section of a light extraction substrate for an OLED that is fabricated according to Example 3 of the present invention;
FIG. 8 is a graph showing a light scattering distribution measured from the light extraction substrate for an OLED that is fabricated according to Example 3 of the present invention;

### DETAILED DESCRIPTION OF THE INVENTION

Reference will now be made in detail to a method of fabricating a light extraction substrate for an organic light-emitting diode (OLED) according to the present invention, embodiments of which are illustrated in the accompanying drawings and described below, so that a person having ordinary skill in the art to which the present invention relates can easily put the present invention into practice.

Throughout this document, reference should be made to the drawings, in which the same reference numerals and signs are used throughout the different drawings to designate the same or similar components. In the following description of the present invention, detailed descriptions of known functions and components incorporated herein will be omitted when they may make the subject matter of the present invention unclear.

The method of fabricating a light extraction substrate for an OLED according to an embodiment of the present invention forms a light extraction layer made of an inorganic oxide by depositing a base substrate with the inorganic oxide by atmospheric pressure chemical vapor deposition (APCVD). The base substrate can be made of any material that has superior light transmittance and superior mechanical properties. For instance, the base substrate can be made of a thermally curable or ultraviolet (UV) curable polymeric material, such as an organic film, or a chemically-tempered glass, such as a soda-lime glass (SiO₂-CaO-Na₂O) or an aluminosilicate glass (SiO₂-Al₂O₃-Na₂O). The soda-lime glass can be used when the OLED is used for illumination, whereas the aluminosilicate glass can be used when the OLED is used for a display.

According to an embodiment of the present invention, an inorganic oxide having a greater refractive index than the base substrate is deposited as a light extraction layer. For example, one inorganic oxide selected from among ZnO, SnO₂, SiO₂, Al₂O₃and TiO₂ can be deposited as a light extraction layer.

According to an embodiment of the present invention, the inorganic oxide is deposited and layered at least twice in order to artificially control the structure of a texture that is naturally formed on the surface of the light extraction layer during APCVD.

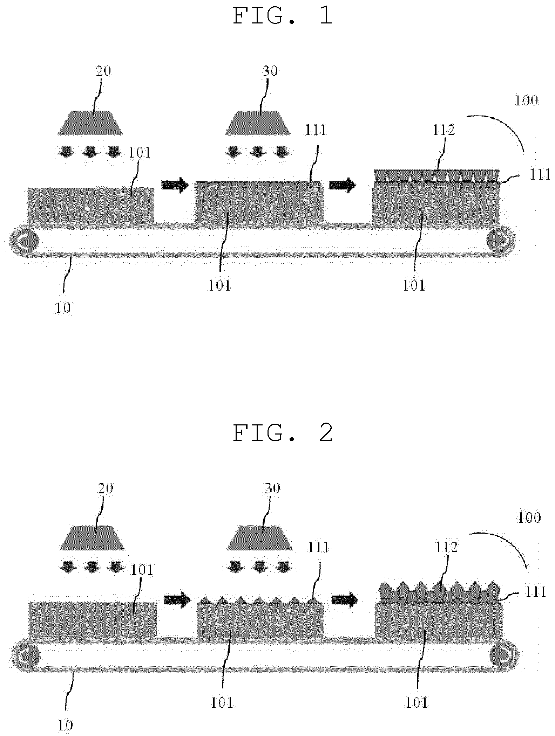

This will be described in more detail with reference to FIG. 1 and FIG. 2. APCVD for forming a light extraction layer 100 can be performed by an in-line process. First, a base substrate 101 is loaded on a belt-type conveyor 10, and the conveyor 10 is started using a controller (not shown) so that the conveyor 10 transports the base substrate 101 in one direction. In this case, an in-line system for APCVD includes a first injector 20 and a second injector 30 which are sequentially disposed in the longitudinal direction of the conveyor 10 such that the first and second injectors 20 and 30 face the upper surface of the base substrate 101. When the base substrate 101 transported on the conveyor 10 is positioned below the first injector 20, the first injector 20 is operated via the controller (not shown) so that it injects a precursor gas and an oxidizer gas toward the base substrate 101, the precursor gas being made of an inorganic oxide to be deposited on the base substrate 101, whereby the inorganic oxide is deposited as a thin film on the base substrate 101. The precursor gas and the oxidizer gas can be injected through different nozzles of the first injector 20 in order to prevent the gases from prematurely mixing. The precursor gas and the oxidizer gas can be fed by being preheated in order to activate a deposition chemical reaction. The precursor gas and the oxidizer gas can be fed to the first injector 20 by being transported on a carrier gas that is implemented as an inert gas such as nitrogen, helium or argon.

According to an embodiment of the present invention, the deposition temperature is controlled by heating the base substrate 101 to a certain temperature before operating the first injector 20. Afterwards, the inorganic oxide is deposited on the base substrate 101 via the first injector 20, whereby a first thin-film layer 111 made of the inorganic oxide is formed on the base substrate 101, as shown in the figure. The first thin-film layer 111 has concaves and convexes on the surface thereof. The concaves and convexes on the surface of the thin-film layer 111 are naturally formed during APCVD.

Afterwards, the base substrate 101 coated with the first thin-film layer 111 is transported further on the conveyor 10 and is positioned below the second injector 30. The base substrate 101 is heated to a certain temperature. In this case, it is possible to form a deposition atmosphere by setting the temperature to which the base substrate 101 is heated to be different from the temperature to which the base substrate 101 is heated when depositing the first thin-film layer 111 via the first injector 20.

After the base substrate 10 is heated, the second injector 30 is operated via the controller (not shown). Specifically, a second thin-film layer 112 is deposited on the first thin-film layer 111 by injecting a precursor gas and an oxidizer gas onto the first thin-film layer 111 via the second injector 30, the precursor gas being made of an inorganic oxide the same as that of the first thin-film layer 111. When the second thin-film layer 112 is deposited on the first thin-film layer 111, the light extraction layer 100 is formed on the base substrate 101. The light extraction layer 100 has a bilayer structure of the first thin-film layer 111 and the second thin-film layer 112 which are deposits of the same oxide. In addition, a texture is formed on the surface of the light extraction layer 100.

According to an embodiment of the present invention, it is possible to inject a dopant into the first thin-film layer 111 and the second thin-film layer 112 in order to control the structure of the texture. Here, according to an embodiment of the present invention, it is possible to supply the dopant along with process gases during APCVD or inject the dopant by, for example, ion implantation after the light extraction layer 100 is finally formed. It is preferred that the content of the dopant that is injected be controlled to be 10wt% or less of the inorganic oxide, for example, zinc oxide (ZnO) of the light extraction layer 100.

According to an embodiment of the present invention, only one difference in process conditions between a first deposition process of depositing the first thin-film layer 111 on the base substrate 101 and a second deposition process of depositing the second thin-film layer 112 on the first thin-film layer 111 is the deposition temperature, i.e. the temperature to which the base substrate 101 is heated. That is, when the temperature of the base substrate 101 is set to a certain temperature in the first deposition process, the first thin-film layer 111 is deposited such that it has a specific configuration including a surface shape, size, thickness, uniformity and the like. The concave-convex structure on the surface of the first thin-film layer 111 has an effect on the surface structure of the second thin-film layer 112 that is deposited during the second deposition process. In other words, the surface structure of the second thin-film layer 112, i.e. the surface texture structure of the light extracting layer 100 that is finally formed, depends or relies on the concave-convex structure of the surface of the first thin-film layer 111.

In this way, according to embodiment of the present invention, it is possible to artificially control the texture structure on the surface of the light extracting layer 100 while realizing a coating thickness required for light extraction by dividing the deposition process into first and second processes and controlling only the deposition temperature without any pretreatment of the base substrate 101 in order to control the texture structure of the light extraction layer 100.

FIG. 1 and FIG. 2 are schematic process views showing processes in which the base substrate in FIG. 1 and the base substrate in FIG. 2 are set to different temperature conditions. In this case, the first thin-film layers 111 are formed such that they have different surface structures, and thus the second thin-film layers 112 are formed such that they have different surface structures. Specifically, it is possible to adjust the surface shape, size, thickness and uniformity of the first thin-film layer 111 by artificially controlling the nucleation and the growth of grain in the first thin-film layer 111 by adjusting only the temperature of the base substrate 101. Due to the difference between the first thin-film layers 111, the shape, size and uniformity of concaves and convexes on the surface of the second thin-film layers 112 become different even if the base substrates 101 in FIG. 1 and FIG. 2 are at the same temperature during the second deposition process. In other words, it is possible to artificially and variously control the texture structure on the surface of the finally-formed light extraction layer 100 depending on to what degree the temperature of the base substrate 101 is set in the first deposition process. Accordingly, when the light extraction substrate fabricated according to an embodiment of the invention is applied to an OLED for illumination, it is possible to control the scattering distribution of light emitted from the OLED depending on the use. In addition, since the method of fabricating a light extraction layer for an OLED according to an embodiment of the present invention causes the texture structure on the surface of the light extraction layer 100 to be naturally formed by APCVD, related-art photolithography for forming a light extraction layer becomes unnecessary. It is therefore possible to reduce fabrication time by reducing the number of process steps. Treatment cost is also reduced since hazardous substances produced by the process are decreased. Furthermore, when the light extraction layer is formed by APCVD, it is possible to set the fabrication of the glass for the base substrate 101 and the formation of the light extraction layer 100 in-line or on-line and the base substrate 101 and the light extraction layer 100 can be integrated with each other, whereby the resultant light extraction substrate can be made by mass-production.

### Example 1

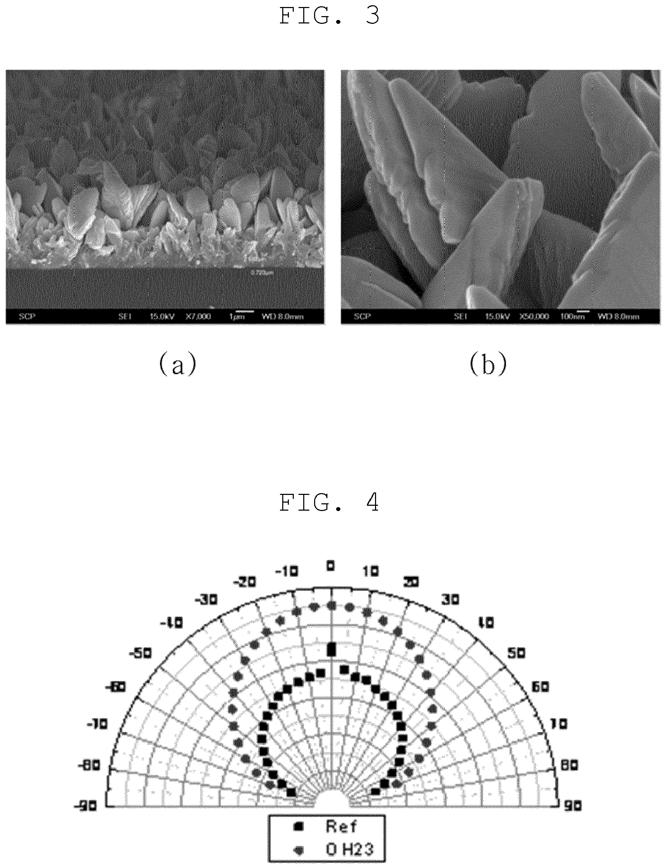

First, a glass substrate was heated to a temperature of 350°C, and then a zinc oxide (ZnO) thin film was deposited on the glass substrate by atmospheric pressure chemical vapor deposition (APCVD). Afterwards, the glass substrate was heated to a temperature of 640°C, and then a ZnO thin film was deposited in line on the ZnO thin film that was deposited in advance, thereby producing a light extraction substrate. The shape of the resultant light extraction substrate was photographed using a scanning electron microscope (SEM), and the light scattering distribution was measured and analyzed, as shown in FIG. 3 and FIG. 4.

Referring to FIG. 3, it is appreciated that concaves and convexes are naturally formed on the surface of the ZnO thin film that is deposited in the lower portion (a) by APCVD and the surface of the ZnO thin film that is deposited in the upper portion (b) has an overall texture structure. It is apparent that the growth direction crystal grains of the ZnO thin film deposited in the upper portion (b) depends or relies on the concave-convex shape of the ZnO thin film in the lower portion (b). The thickness of the lower ZnO thin film (a) was measured to be 0.7pm, and the thickness of the upper ZnO thin film (b) was measured to be 2.7µm. In addition, referring to FIG. 4, the front-view luminance of the light extraction substrate fabricated according to Example 1 (red) was measured to be improved 43% from that of a substrate without a light extraction layer (black).

### Example 2

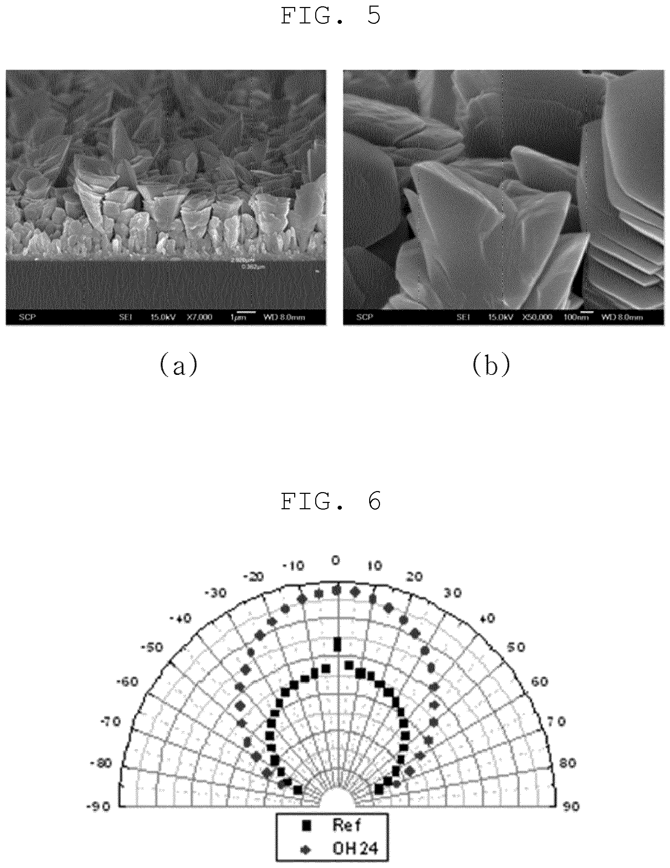

First, a glass substrate was heated to a temperature of 400°C, and then a ZnO thin film was deposited on the glass substrate by APCVD. Afterwards, the glass substrate was heated to a temperature of 640°C, and then a ZnO thin film was deposited in line on the ZnO thin film that was deposited in advance, thereby producing a light extraction substrate. The shape of the resultant light extraction substrate was photographed using a SEM, and the light scattering distribution was measured and analyzed, as shown in FIG. 5 and FIG. 6.

Referring to FIG. 5, it is appreciated that concaves and convexes are naturally formed on the surface of the ZnO thin film that is deposited in the lower portion (a) by APCVD and the surface of the ZnO thin film that is deposited in the upper portion (b) has an overall texture structure. It is apparent that the growth direction crystal grains of the ZnO thin film deposited in the upper portion (b) depends or relies on the concave-convex shape of the ZnO thin film in the lower portion (b). The thickness of the lower ZnO thin film (a) was measured to be 0.4pm, and the thickness of the upper ZnO thin film (b) was measured to be 2.9pm. In addition, referring to FIG. 6, the front-view luminance of the light extraction substrate fabricated according to Example 2 (red) was measured to be improved 49% from that of a substrate without a light extraction layer (black).

### Example 3

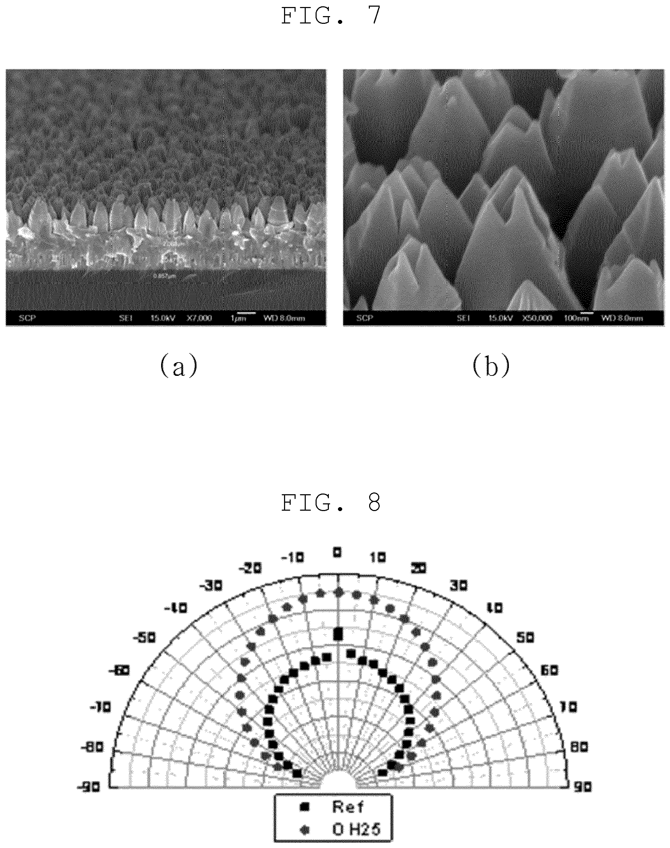

First, a glass substrate was heated to a temperature of 450°C, and then a ZnO thin film was deposited on the glass substrate by APCVD. Afterwards, the glass substrate was heated to a temperature of 640°C, and then a ZnO thin film was deposited in line on the ZnO thin film that was deposited in advance, thereby producing a light extraction substrate. The shape of the resultant light extraction substrate was photographed using a SEM, and the light scattering distribution was measured and analyzed, as shown in FIG. 7 and FIG. 8.

Referring to FIG. 7, it is appreciated that concaves and convexes are naturally formed on the surface of the ZnO thin film that is deposited in the lower portion (a) by APCVD and the surface of the ZnO thin film that is deposited in the upper portion (b) has an overall texture structure. It is apparent that the growth direction of crystal grains of the ZnO thin film deposited in the upper portion (b) depends or relies on the concave-convex shape of the ZnO thin film in the lower portion (b). The thickness of the lower ZnO thin film (a) was measured to be 1.7pm, and the thickness of the upper ZnO thin film (b) was measured to be 2.1µm. In addition, referring to FIG. 8, the front-view luminance of the light extraction substrate fabricated according to Example 3 (red) was measured to be improved 49% from that of a substrate without a light extraction layer (black).

Referring to Example 1 to Example 3, it can be concluded that all of the texture structures are naturally formed on the surfaces of the light extraction layers by APCVD. It can also be concluded that, when the ZnO thin films are initially deposited, the deposited ZnO thin films are imparted with different surface structures due to the different temperatures. In addition, it can be concluded that the surface structures of the ZnO thin films that are subsequently deposited depend on the surface structures of the ZnO thin films that are initially deposited. Accordingly, the finally-formed light extraction layers have different texture structures.

The foregoing descriptions of specific exemplary embodiments of the present invention have been presented with respect to the drawings. They are not intended to be exhaustive or to limit the present invention to the precise forms disclosed, and obviously many modifications and variations are possible for a person having ordinary skill in the art in light of the above teachings.

It is intended therefore that the scope of the present invention not be limited to the foregoing embodiments, but be defined by the Claims appended hereto.

## Claims

1. A method of fabricating a light extraction substrate for an organic light-emitting diode, comprising forming a light extraction layer (100) by depositing an inorganic oxide (111, 112) by atmospheric pressure chemical vapor deposition (APCVD) at least twice on a base substrate (101), thereby controlling a structure of a texture formed on a surface of the light extraction layer (100) wherein depositing the inorganic oxide (111, 112) at least twice comprises:
depositing the inorganic oxide on the base substrate (101) at a first deposition temperature to form a first thin-film layer (111) having a concave-convex structure on a surface thereof; and
depositing the inorganic oxide at a second deposition temperature on the first thin-film layer (111) to form a second thin-film layer (112) having a surface structure depending on the concave-convex structure of the surface of the first thin-film layer, thereby forming the light extraction layer (100) having a bilayer structure and a texture structure on a surface thereof,
wherein a thickness of the first thin-film layer (111) ranging from 0.4 to 1.7 µm and a thickness of the second thin-film layer (112) ranging from 2.1 to 2.9 µm and wherein the first deposition temperature is different from the second deposition temperature.

2. The method of claim 1, wherein the first deposition temperature and the second deposition temperature are different from each other and range from 350 to 640°C.

3. The method of claim 1, wherein depositing the inorganic oxide at least twice is implemented as an in-line process.

4. The method of claim 1, wherein the inorganic oxide comprises a substance having a greater refractive index than the base substrate.

5. The method of claim 4, wherein the inorganic oxide comprises one selected from a group of inorganic substances consisting of ZnO, SnO₂, SiO₂, Al₂O₃ and TiO₂.

6. The method of claim 1, further comprising injecting a dopant during or after depositing the inorganic oxide at least twice.

## Patentansprüche

1. Verfahren zur Herstellung eines Lichtauskopplungssubstrats für eine organische lichtemittierende Diode, umfassend das Ausbilden einer Lichtauskopplungsschicht (100) durch Abscheiden eines anorganischen Oxids (111, 112) durch mindestens zweimalige chemische Abscheidung aus der Gasphase bei Atmosphärendruck (APCVD) auf einem Basissubstrat (101), dadurch Regulieren einer Oberflächenstruktur, die auf einer Oberfläche der Lichtauskopplungsschicht (100) gebildet wird, wobei das mindestens zweimalige Abscheiden des anorganischen Oxids (111, 112) umfasst:
Abscheiden des anorganischen Oxids auf dem Basissubstrat (101) bei einer ersten Abscheidungstemperatur, um eine erste Dünnfilmschicht (111) mit einer konkav-konvexen Struktur auf einer Oberfläche davon auszubilden; und
Abscheiden des anorganischen Oxids bei einer zweiten Abscheidungstemperatur auf der ersten Dünnfilmschicht (111), um eine zweite Dünnfilmschicht (112) mit einer Oberflächenstruktur in Abhängigkeit von der konkav-konvexen Struktur der Oberfläche der ersten Dünnfilmschicht auszubilden, dadurch Ausbilden der Lichtauskopplungsschicht (100) mit einer Zweischichtstruktur und einer Oberflächenstruktur auf einer Oberfläche davon,
wobei eine Dicke der ersten Dünnfilmschicht (111) von 0,4 bis 1,7 µm reicht und eine Dicke der zweiten Dünnfilmschicht (112) von 2,1 bis 2,9 µm reicht und
wobei sich die erste Abscheidungstemperatur von der zweiten Abscheidungstemperatur unterscheidet.

2. Verfahren nach Anspruch 1, wobei sich die erste Abscheidungstemperatur und die zweite Abscheidungstemperatur voneinander unterscheiden und von 350 bis 640 °C reichen.

3. Verfahren nach Anspruch 1, wobei das mindestens zweimalige Abscheiden des anorganischen Oxids als Inline-Prozess durchgeführt wird.

4. Verfahren nach Anspruch 1, wobei das anorganische Oxid einen Stoff mit einem höheren Brechungsindex als das Basissubstrat umfasst.

5. Verfahren nach Anspruch 4, wobei das anorganische Oxid eines, ausgewählt aus einer Gruppe von anorganischen Stoffen, bestehend aus ZnO, SnO₂, SiO₂, Al₂O₃ und TiO₂, umfasst.

6. Verfahren nach Anspruch 1, weiterhin umfassend das Injizieren eines Dotanten während des oder nach dem mindestens zweimaligen Abscheiden(s) des anorganischen Oxids.

## Revendications

1. Procédé de fabrication d'un substrat d'extraction de lumière pour une diode électroluminescente organique, comprenant former une couche d'extraction de lumière (100) en déposant un oxyde inorganique (111, 112) par dépôt chimique en phase vapeur à pression atmosphérique (APCVD) au moins deux fois sur un substrat de base (101), contrôlant ainsi une structure d'une texture formée sur une surface de la couche d'extraction de lumière (100) déposer l'oxyde inorganique (111, 112) au moins deux fois comprenant :
déposer l'oxyde inorganique sur le substrat de base (101) à une première température de dépôt pour former une première couche mince (111) ayant une structure concave-convexe sur une surface de celle-ci ;
et
déposer l'oxyde inorganique à une deuxième température de dépôt sur la première couche mince (111) pour former une deuxième couche mince (112) ayant une structure de surface dépendant de la structure concave-convexe de la surface de la première couche mince, formant ainsi la couche d'extraction de lumière (100) ayant une structure bicouche et une structure de texture sur une surface de celle-ci,
une épaisseur de la première couche mince (111) se trouvant dans la plage de 0,4 à 1,7 µm et une épaisseur de la deuxième couche mince (112) se trouvant dans la plage de 2,1 à 2,9 µm et
la première température de dépôt étant différente de la deuxième température de dépôt.

2. Procédé selon la revendication 1, la première température de dépôt et la deuxième température de dépôt étant différentes l'une de l'autre et se trouvant dans la plage de 350 à 640 °C.

3. Procédé selon la revendication 1, déposer l'oxyde inorganique au moins deux fois étant implémenté comme un procédé en ligne.

4. Procédé selon la revendication 1, l'oxyde inorganique comprenant une substance dont l'indice de réfraction est supérieur à celui du substrat de base.

5. Procédé selon la revendication 4, l'oxyde inorganique comprenant l'une des substances inorganiques sélectionnées parmi le groupe se composant de ZnO, SnO₂, SiO₂, Al₂O₃ et TiO₂.

6. Procédé selon la revendication 1, comprenant en outre injecter un dopant pendant ou après le dépôt au moins deux fois de l'oxyde inorganique.
